# EUROPEAN PATENT APPLICATION

(11) **EP 3 444 918 A1**
(43) Date of publication of application: **20.02.2019**
(21) Application number: 18187042.9
(22) Date of filing: 02.08.2018
(51) Int. Cl.: H02J 7/00, B60L 11/18, G01R 31/36

(54) **METHOD AND APPARATUS FOR CHARGING MANAGEMENT, CHARGING DEVICE AND MACHINE READABLE MEDIUM**

(30) Priority: 16.08.2017 CN 201710700934
(71) Applicant: Robert Bosch GmbH, 70442 Stuttgart (DE)
(72) Inventor: RECHKEMMER, Sabrina Kathrin, Shanghai, 200335 (CN); Sawodny, Oliver, Shanghai, 200335 (CN); Zang, Xiaoyun, Shanghai, 200335 (CN); Li, Weiya, Shanghai, 200335 (CN)

(57) **Abstract**

The present invention relates to a method and apparatus for charging management, the method comprising: using travel data of an electric vehicle of all historical days, including a current day, prior to a second day to estimate a possible depth of discharge (DOD) of a battery supplying power to the electric vehicle on the second day and a degree of ageing of the battery as of the current day, wherein the travel data indicates the variation with time of a travel speed of the electric vehicle on all the historical days; determining an optimal state of charge (SOC) range of the battery corresponding to the estimated degree of ageing, on the basis of information indicating optimal SOC ranges of the battery corresponding to different degrees of ageing of the battery; determining a maximum SOC of the battery when used on the second day, on the basis of the estimated possible DOD and the determined optimal SOC range; and charging the battery to the maximum SOC, when the battery can be charged for use on the second day. The method and apparatus can prolong the life of the battery supplying power to the electric vehicle.

## Description

### Technical field

The present invention relates to the field of batteries, in particular to a method and apparatus for charging management, a charging device and a machine-readable medium.

### Background art

Two-wheeled electric vehicles such as electric bicycles use a battery to supply the energy needed for travelling. When the remaining quantity of charge in a battery of a two-wheeled electric vehicle is inadequate, a charging device is used to supply external electrical energy to the battery, so that the battery can continue to supply the energy needed for travelling to the two-wheeled electric vehicle.

The battery is the most expensive component of a two-wheeled electric vehicle. Although the nominal lifespan of a battery is long, it is generally necessary to replace the battery of a two-wheeled electric vehicle after one to two years, and this makes the cost of using the two-wheeled electric vehicle very high.

### Content of the invention

Embodiments of the present invention provide a method and apparatus for charging management, a charging device and a machine-readable medium, which are capable of prolonging the life of a battery supplying power to an electric vehicle.

A method for charging management according to an embodiment of the present invention comprises: using travel data of an electric vehicle of all historical days, including a current day, prior to a second day to estimate a possible depth of discharge (DOD) of a battery supplying power to the electric vehicle on the second day and a degree of ageing of the battery as of the current day, wherein the travel data indicates the variation with time of a travel speed of the electric vehicle on all the historical days; determining an optimal state of charge (SOC) range of the battery corresponding to the estimated degree of ageing, on the basis of pre-acquired information indicating optimal SOC ranges of the battery corresponding to different degrees of ageing of the battery; determining a maximum SOC of the battery when used on the second day, on the basis of the estimated possible DOD and the determined optimal SOC range; and charging the battery to the maximum SOC, when the battery can be charged for use on the second day.

An apparatus for charging management according to an embodiment of the present invention comprises: an estimation module, for using historical travel data of an electric vehicle of all historical days, including a current day, prior to a second day to estimate a possible DOD of a battery supplying power to the electric vehicle on the second day and a degree of ageing of the battery as of the current day, wherein the travel data indicates the variation with time of a travel speed of the electric vehicle on all the historical days; a first determining module, for determining an optimal SOC range of the battery corresponding to the estimated degree of ageing, on the basis of pre-acquired information indicating optimal SOC ranges of the battery corresponding to different degrees of ageing of the battery; and determining a maximum SOC of the battery when used on the second day, on the basis of the estimated possible DOD and the determined optimal SOC range; and a charging module, for charging the battery to the maximum SOC, when the battery can be charged for use on the second day.

A charging device according to an embodiment of the present invention comprises: a processor; and a memory, in which is stored an executable instruction which, when executed, causes the processor to perform the abovementioned method.

A machine-readable storage medium according to an embodiment of the present invention stores an executable instruction which, when executed, causes a machine to perform the abovementioned method.

It can be seen from the foregoing that in the solution in embodiments of the present invention, a charging scheme which reduces battery ageing is implemented for the battery supplying power to the electric vehicle by taking into account electric vehicle travel data characterizing user behaviour; thus, the solution in embodiments of the present invention can prolong the life of the battery supplying power to the electric vehicle.

### Description of the accompanying drawings

Features, characteristics, advantages and benefits of the present invention will become obvious through the following detailed description, which makes reference to the accompanying drawings.
Fig. 1 shows a general flow chart of a method for charging management according to an embodiment of the present invention.
Fig. 2 shows an example of travel data according to an embodiment of the present invention.
Fig. 3 shows a flow chart of a method for charging management according to an embodiment of the present invention.
Fig. 4 shows a schematic diagram of an apparatus for charging management according to an embodiment of the present invention.
Fig. 5 shows a schematic diagram of a charging device according to an embodiment of the present invention.

### Particular embodiments

Various embodiments of the present invention are described in detail below with reference to the accompanying drawings.

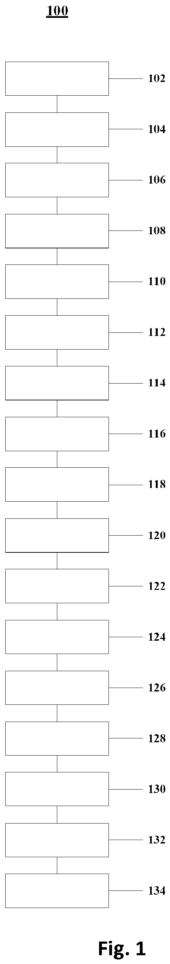

Fig. 1 shows a general flow chart of a method for charging management according to an embodiment of the present invention. The method 100 shown in fig. 1 is realized by a charging device CD for charging a battery BA, wherein the battery BA supplies power to a two-wheeled electric vehicle CH so as to supply the energy needed for travelling to the two-wheeled electric vehicle CH.

As shown in fig. 1, in box 102, the charging device CD acquires historical travel data QX of the electric vehicle CH of all historical days, including a current day D1, prior to a second day D2, wherein the travel data of each historical day indicates the variation with time of a travel speed of the electric vehicle CH on that day. The travel data QX may be collected by the charging device CD itself. Alternatively, another device on the electric vehicle CH collects the travel data QX and stores same in a memory, then the charging device CD acquires the travel data QX from the memory.

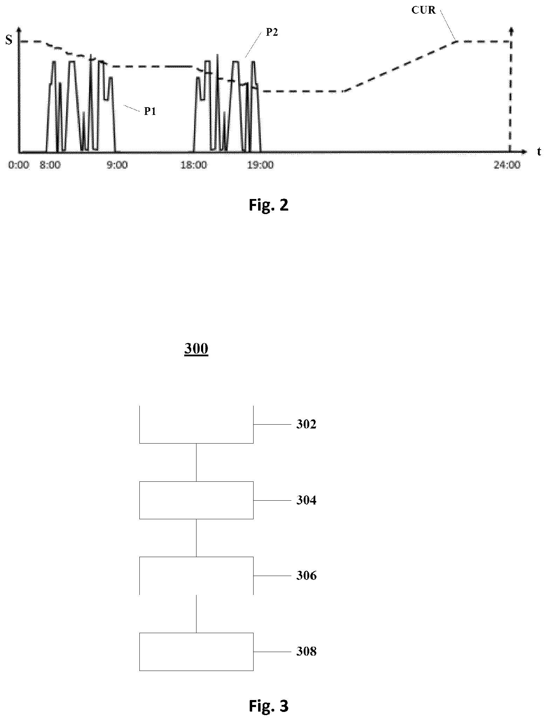

The travel data QX may be of a commuting cycle type. Travel data QX of the commuting cycle type occurs in the form of just two speed trace clusters each day, wherein one speed trace cluster occurs in the morning, being the result of a user driving the electric vehicle CH to a place of work, and the other speed trace cluster occurs at dusk or in the evening, being the result of the user driving the electric vehicle CH back home. Fig. 2 shows an example of travel data of the commuting cycle type, wherein the vertical axis represents the travel speed S of the electric vehicle CH, and the horizontal axis represents time t. As shown in fig. 2, the travel data QX of the commuting cycle type occurs in the form of just two speed trace clusters P1 and P2 each day, wherein speed trace cluster P1 occurs in the morning in the period 8:00 - 9:00, and speed trace cluster P2 occurs in the evening in the period 18:00 - 19:00.

In addition, the travel data QX may also be of an express delivery cycle type. Travel data QX of the express delivery cycle type is generated by a courier driving the electric vehicle CH to deliver express mail items; a characteristic of express delivery is that the courier is driving the electric vehicle CH all day, only stopping occasionally to deliver express mail items to recipients.

The cycle types of travel data of all historical days may be identical or different.

In box 104, the charging device CD uses a known relationship between the travel speed of the electric vehicle CH and a discharge amount per unit time of the battery BA, to convert the variation with time of the travel speed of the electric vehicle CH on all historical days indicated by the acquired travel data QX of all historical days, so as to obtain the variation with time of the discharge amount per unit time of the battery BA on all historical days. For example, supposing that historical data is travel data of the current day D1 and a day D3, which is the day before the current day D1, then the variation with time of the travel speed of the electric vehicle CH on the current day D1 indicated by the acquired travel data QX of the current day D1 is converted so as to obtain the variation with time of the discharge amount per unit time of the battery BA on the current day D1, and the variation with time of the travel speed of the electric vehicle CH on the preceding day D3 indicated by the acquired travel data QX of the preceding day D3 is converted so as to obtain the variation with time of the discharge amount per unit time of the battery BA on the preceding day D3.

In box 106, the charging device CD uses the obtained variation with time of the discharge amount per unit time of the battery BA on all historical days, to calculate by an integration operation a cumulative consumed charge quantity of the battery BA at each moment of all historical days. The cumulative consumed charge quantity of the battery BA at each moment of all historical days represents the quantity of charge which the battery BA cumulatively consumes, from a zero point of every historical day to the moment in question. For example, supposing that all historical days are the current day D1 and the preceding day D3, then the cumulative consumed charge quantity of the battery BA at each moment of the current day D1 and the cumulative consumed charge quantity of the battery BA at each moment of the preceding day D3 are calculated.

In box 108, the charging device CD uses a total charge quantity of the battery BA at the zero point of every historical day, and the cumulative consumed charge quantity of the battery BA at each moment of every historical day, to calculate a remaining charge quantity of the battery BA at each moment of every historical day.

In box 110, the charging device CD uses the total charge quantity of the battery BA at the zero point of every historical day, and the remaining charge quantity of the battery BA at each moment of every historical day, to calculate a state of charge (SOC) of the battery BA at each moment of every historical day, and thereby obtains the variation with time of the SOC of the battery BA on all historical days, such as the dotted line CUR shown in fig. 2.

In box 112, the charging device CD calculates the difference between a maximum SOC and a minimum SOC obtained from the variation with time of the SOC of the battery BA on all historical days, to serve as a depth of discharge (DOD) of the battery BA on all historical days. For example, supposing that all historical days are the current day D1 and the preceding day D3, then the difference between a maximum SOC and a minimum SOC obtained from the variation with time of the SOC of the battery BA on the current day D1 is calculated as the DOD of the battery BA on the current day D1, and the difference between a maximum SOC and a minimum SOC obtained from the variation with time of the SOC of the battery BA on the preceding day D3 is calculated as the DOD of the battery BA on the preceding day D3.

In box 114, the DOD of the battery BA on all historical days is used to estimate a possible DOD of the battery BA on the second day D2. For example, the value of a weighted sum of the DODs of the battery BA on all historical days may be calculated as the possible DOD of the battery BA on the second day D2. As another example, the largest DOD amongst the DODs of the battery BA on all historical days may be chosen as the possible DOD of the battery BA on the second day D2. As another example, the mean value of the DODs of the battery BA on all historical days may be calculated as the possible DOD of the battery BA on the second day D2. As another example, the DOD located at the median position amongst the DODs of the battery BA on all historical days may be chosen as the possible DOD of the battery BA on the second day D2.

In box 116, the charging device CD determines, from the variation with time of the SOC of the battery BA on the current day D1, a discharge time and a charge time of the battery BA on the current day D1. In the variation with time of the SOC of the battery BA on the current day D1, a moment when the SOC is decreasing is a moment when the battery BA is discharging, and a moment when the SOC is increasing is a moment when the battery BA is being charged. The sum of durations of SOC decreases in the variation with time of the SOC of the battery BA on the current day D1 is the discharge time of the battery BA on the current day D1, and the sum of durations of SOC increases in the variation with time of the SOC of the battery BA on the current day D1 is the charge time of the battery BA on the current day D1.

In box 118, the charging device CD determines, on the basis of a known relationship between the charge/discharge time of the battery BA and an ageing change amount of the battery BA, an ageing amount experienced by the battery BA on the current day D1 as a result of the discharge time and the charge time of the battery BA on the current day D1.

In box 120, the charging device CD calculates the sum of the ageing amount experienced by the battery BA on the current day D1, a natural ageing amount experienced by the battery BA in one day and a degree of ageing of the battery BA as of the preceding day D3 (i.e. the day before the current day D1), as a degree of ageing of the battery BA as of the current day D1. The natural ageing amount experienced by the battery BA in one day is the amount of ageing experienced naturally by the battery BA in one day in the absence of discharging and charging.

In box 122, the charging device CD retrieves, from pre-acquired information indicating optimal SOC ranges of the battery BA corresponding to different degrees of ageing of the battery BA, an optimal SOC range of the battery BA corresponding to the degree of ageing of the battery BA as of the current day D1.

In box 124, the charging device CD determines, on the basis of the optimal SOC range retrieved in box 122 and the possible DOD calculated in box 114, an initial maximum SOC of the battery BA when used on the second day D2, which is the day after the current day D1.

In box 126, the charging device CD acquires information for indicating weather conditions in a region where the electric vehicle CH is located. As a non-limiting example, the charging device CD may acquire the information from a server providing a weather forecast via a mobile phone of the user of the electric vehicle CH or through a network.

In box 128, the charging device CD adjusts the initial maximum SOC determined in box 124 according to the information acquired in box 126, so as to obtain a maximum SOC of the battery BA when used on the second day D2. For example, supposing that the information acquired in box 126 indicates that there will be snowfall or rainfall etc. with a drop in temperature in the region where the electric vehicle CH is located on the second day D2, then the initial maximum SOC can be increased and the increased initial maximum SOC can be taken to be the maximum SOC of the battery BA when used on the second day D2. As another example, supposing that the information acquired in box 126 indicates that there will be a large increase in temperature in the region where the electric vehicle CH is located on the second day D2, then the initial maximum SOC can be decreased and the decreased initial maximum SOC can be taken to be the maximum SOC of the battery BA when used on the second day D2.

In box 130, the charging device CD uses an optimization algorithm such as gradient descent, a genetic algorithm or an ant colony algorithm to calculate an optimal charging current distribution used to charge the battery BA to the maximum SOC determined in box 126, on the basis of a current remaining charge quantity, temperature and SOC of the battery BA and the degree of ageing of the battery BA as of the current day D1, wherein the charging of the battery BA in accordance with the optimal charging current distribution will result in the smallest ageing amount or the smallest power consumption, etc. The optimal charging current distribution indicates a length of time needed for charging and an optimal charging current at each moment during charging.

In box 132, when the battery BA can be charged, the charging device CD determines a start time for charging the battery BA, on the basis of a current moment and the length of time needed for charging indicated by the optimal charging current distribution calculated in box 130.

In box 134, when a current time reaches the start time determined in box 132, the charging device CD begins charging the battery BA in accordance with the optimal charging current at each moment during charging indicated by the optimal charging current distribution calculated in box 130, until the maximum SOC determined in box 128 is reached.

It can be seen from the description above that in the solution of this embodiment, a charging scheme which reduces battery ageing is implemented for the battery supplying power to the electric vehicle by taking into account electric vehicle travel data characterizing user behaviour; thus, the solution of this embodiment can prolong the life of the battery.

### Other variants

Those skilled in the art should understand that although the method 100 comprises boxes 130 - 134 in the embodiment above, so as to acquire the optimal charging current distribution used to charge the battery BA and then charge the battery BA in accordance with the optimal charging current distribution, the present invention is not limited to this. In other embodiments of the present invention, the method 100 does not include boxes 130 - 134, but pre-determines and acquires information indicating optimal charging currents of the battery BA corresponding to different degrees of ageing of the battery BA, then retrieves from this information an optimal charging current of the battery BA corresponding to the degree of ageing of the battery BA as of the current day D1, and when the battery BA can be charged for use on the second day, charges the battery BA in accordance with the retrieved optimal charging current, until the maximum SOC determined in box 128 is reached. Alternatively, in other embodiments of the present invention, the method 100 does not include boxes 130 - 134, but uses a random charging current (e.g. a charging current used on the previous occasion that the battery BA was charged, etc.) to charge the battery BA when the battery BA can be charged for use on the second day, until the maximum SOC determined in box 128 is reached.

Those skilled in the art should understand that although the charging device CD uses the acquired travel data QX directly to obtain the variation with time of the discharge amount per unit time of the battery BA on all historical days in box 104 in the embodiment above, the present invention is not limited to this. In other embodiments of the present invention, it is possible to first of all subject the travel data QX to some optimization processing, and then to use the optimized travel data QX to obtain the variation with time of the discharge amount per unit time of the battery BA on all historical days.

Those skilled in the art should understand that although the method 100 comprises boxes 116 - 120 in the embodiment above, so as to determine the degree of ageing of the battery BA as of the current day D1, the present invention is not limited to this. In other embodiments of the present invention, the method 100 may not include boxes 116 - 120; instead, the method determines a system state (including but not limited to a maximum SOC capable of being reached by the battery BA, a battery voltage capable of being reached by the battery BA, etc.) of the battery BA as of the current day D1, then looks up, from a pre-acquired battery ageing curve lookup table for indicating different system states of the battery BA and degrees of ageing corresponding thereto, a degree of ageing corresponding to the system state of the battery BA as of the current day D1, to serve as the degree of ageing of the battery BA as of the current day D1. Those skilled in the art should understand that although the method 100 comprises boxes 126 - 128 in the embodiment above, so as to obtain the maximum SOC of the battery BA when used on the second day D2, the present invention is not limited to this. In other embodiments of the present invention, the method 100 may not include boxes 126 - 128; instead, the method directly takes the initial maximum SOC of the battery BA when used on the second day D2 determined in box 124 as the maximum SOC of the battery BA when used on the second day D2.

Those skilled in the art should understand that the method 100 is not only suitable for batteries which supply power to two-wheeled electric vehicles, but is also suitable for batteries which supply power to other types of electric vehicle.

Fig. 3 shows a flow chart of a method for charging management according to an embodiment of the present invention. The method 300 shown in fig. 3 may for example be realized by a charging device.

As shown in fig. 3, the method 300 may comprise, in box 302, using travel data of an electric vehicle of all historical days, including a current day, prior to a second day to estimate a possible DOD of a battery supplying power to the electric vehicle on the second day and a degree of ageing of the battery as of the current day, wherein the travel data indicates the variation with time of a travel speed of the electric vehicle on all the historical days.

The method 300 may further comprise, in box 304, determining, on the basis of pre-acquired information indicating optimal SOC ranges of the battery corresponding to different degrees of ageing of the battery, an optimal SOC range of the battery corresponding to the estimated degree of ageing.

The method 300 may further comprise, in box 306, determining, on the basis of the estimated possible DOD and the determined optimal SOC range, a maximum SOC of the battery when used on the second day.

The method 300 may further comprise, in box 308, charging the battery to the maximum SOC when the battery can be charged for use on the second day.

In a first aspect, the step of estimating the possible DOD of the battery on the second day comprises: acquiring, on the basis of the travel data of all the historical days and a relationship between the travel speed of the electric vehicle and a discharge amount per unit time of the battery, the variation with time of the discharge amount per unit time of the battery on all the historical days; determining the variation with time of an SOC of the battery on all the historical days, on the basis of the variation with time of the discharge amount per unit time of the battery on all the historical days; calculating a DOD of the battery on all the historical days, on the basis of a maximum SOC and a minimum SOC in the variation with time of the SOC of the battery on all the historical days; and calculating the possible DOD on the basis of the DOD of the battery on all the historical days.

In a second aspect, the step of estimating the degree of ageing of the battery as of the current day comprises: determining a discharge time and a charge time of the battery on the current day, on the basis of the travel data of the current day; appraising an ageing amount experienced by the battery on the current day, on the basis of the determined discharge time and charge time; and determining the degree of ageing of the battery as of the current day, on the basis of the appraised ageing amount, a natural ageing amount experienced by the battery in one day and a degree of ageing of the battery as of the day before the current day.

In a third aspect, the step of estimating the degree of ageing of the battery as of the current day comprises: determining a system state of the battery as of the current day; and looking up, from a battery ageing curve lookup table for indicating different system states of the battery and degrees of ageing corresponding thereto, a degree of ageing corresponding to the system state of the battery as of the current day, to serve as the degree of ageing of the battery as of the current day.

In a fourth aspect, box 306 comprises: determining an initial maximum SOC of the battery when used on the second day, using the estimated possible DOD and the determined optimal SOC range; and adjusting the initial maximum SOC according to information for indicating weather conditions in a region where the electric vehicle is located, so as to obtain the maximum SOC of the battery when used on the second day.

In a fifth aspect, the method 300 may further comprise: using an optimization algorithm to calculate an optimal charging current distribution used to charge the battery to the maximum SOC, on the basis of a current remaining charge quantity, temperature and SOC of the battery and the degree of ageing of the battery as of the current day, the optimal charging current distribution indicating a length of time needed for charging and an optimal charging current at each moment during charging; and determining a start time for charging the battery on the basis of a current moment and the length of time indicated by the optimal charging current distribution, when the battery can be charged for use on the second day, wherein box 308 comprises: charging the battery in accordance with the optimal charging current at each moment during charging indicated by the optimal charging current distribution, when a current time reaches the start time.

In a sixth aspect, the method 300 may further comprise: determining an optimal charging current of the battery corresponding to the estimated degree of ageing, using pre-acquired information indicating optimal charging currents of the battery corresponding to different degrees of ageing of the battery, wherein box 308 comprises: charging the battery in accordance with the determined optimal charging current, until the maximum SOC is reached, when the battery can be charged for use on the second day.

In a seventh aspect, the electric vehicle is a two-wheeled electric vehicle.

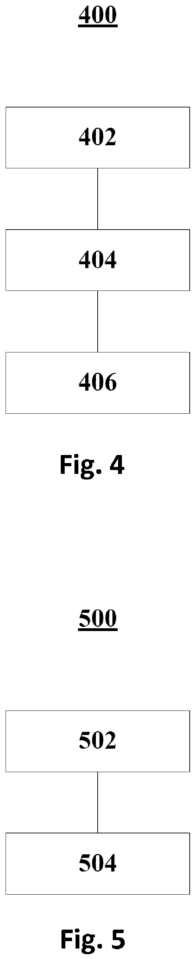

Fig. 4 shows a schematic diagram of an apparatus for charging management according to an embodiment of the present invention. The apparatus 400 shown in fig. 4 may be realized using software, hardware or a combination of software and hardware, and may for example be, but is not limited to being, installed in a charging device, etc.

As shown in fig. 4, the apparatus 400 may comprise an estimation module 402, a first determining module 404 and a charging module 406. The estimation module 402 is for using travel data of an electric vehicle of all historical days, including a current day, prior to a second day to estimate a possible DOD of a battery supplying power to the electric vehicle on the second day and a degree of ageing of the battery as of the current day, wherein the travel data indicates the variation with time of a travel speed of the electric vehicle on all the historical days. The first determining module 404 is for determining an optimal SOC range of the battery corresponding to the estimated degree of ageing, on the basis of pre-acquired information indicating optimal SOC ranges of the battery corresponding to different degrees of ageing of the battery; and determining a maximum SOC of the battery when used on the second day, on the basis of the estimated possible DOD and the determined optimal SOC range. The charging module 406 is for charging the battery to the maximum SOC, when the battery can be charged for use on the second day.

In a first aspect, the estimation module 402 comprises: an acquisition module, for acquiring, on the basis of the travel data of all the historical days and a relationship between the travel speed of the electric vehicle and a discharge amount per unit time of the battery, the variation with time of the discharge amount per unit time of the battery on all the historical days; a second determining module, for determining the variation with time of an SOC of the battery on all the historical days, on the basis of the variation with time of the discharge amount per unit time of the battery on all the historical days; a first calculation module, for calculating a DOD of the battery on all the historical days, on the basis of a maximum SOC and a minimum SOC in the variation with time of the SOC of the battery on all the historical days; and a second calculation module, for calculating the possible DOD on the basis of the DOD of the battery on all the historical days.

In a second aspect, the estimation module 402 comprises: a third determining module, for determining a system state of the battery as of the current day; and a lookup module, for looking up, from a battery ageing curve lookup table for indicating different system states of the battery and degrees of ageing corresponding thereto, a degree of ageing corresponding to the system state of the battery as of the current day, to serve as the degree of ageing of the battery as of the current day.

In a third aspect, the first determining module 404 comprises: a fourth determining module, for determining an initial maximum SOC of the battery when used on the second day, using the estimated possible DOD and the determined optimal SOC range; and an adjustment module, for adjusting the initial maximum SOC according to information for indicating weather conditions in a region where the electric vehicle is located, so as to obtain the maximum SOC of the battery when used on the second day.

In a fourth aspect, the estimation module 402 comprises: a fifth determining module, for determining a discharge time and a charge time of the battery on the current day, on the basis of the travel data of the current day; an appraisal module, for appraising an ageing amount experienced by the battery on the current day, on the basis of the determined discharge time and charge time; and a sixth determining module, for determining the degree of ageing of the battery as of the current day, on the basis of the appraised ageing amount, a natural ageing amount experienced by the battery in one day and a degree of ageing of the battery as of the day before the current day.

In a fifth aspect, the apparatus 400 may further comprise: a third calculation module, for using an optimization algorithm to calculate an optimal charging current distribution used to charge the battery to the maximum SOC, on the basis of a current remaining charge quantity, temperature and SOC of the battery and the degree of ageing of the battery as of the current day, the optimal charging current distribution indicating a length of time needed for charging and an optimal charging current at each moment during charging; and a seventh determining module, for determining a start time for charging the battery on the basis of a current moment and the length of time indicated by the optimal charging current distribution, when the battery can be charged for use on the second day, wherein the charging module 406 is used for: charging the battery in accordance with the optimal charging current at each moment during charging indicated by the optimal charging current distribution, when a current time reaches the start time.

In a sixth aspect, the apparatus 400 may further comprise: an eighth determining module, for determining an optimal charging current of the battery corresponding to the estimated degree of ageing, using pre-acquired information indicating optimal charging currents of the battery corresponding to different degrees of ageing of the battery, wherein the charging module 406 is used for: charging the battery in accordance with the determined optimal charging current, until the maximum SOC is reached, when the battery can be charged for use on the second day.

In a seventh aspect, the electric vehicle is a two-wheeled electric vehicle.

Fig. 5 shows a schematic diagram of a charging device according to an embodiment of the present invention. As shown in fig. 5, the charging device 500 may comprise a processor 502 and a memory 504. Stored in the memory 504 is an executable instruction which, when executed, causes the processor 502 to perform the method 300 shown in fig. 3.

An embodiment of the present invention also provides a machine-readable storage medium, on which is stored an executable instruction which, when executed, causes a machine to perform the method 300 shown in fig. 3.

Those skilled in the art will understand that various alterations, amendments and/or adjustments could be made to all embodiments disclosed in the present invention without deviating from the substance thereof; all such alterations, amendments and/or adjustments fall within the scope of protection of the present invention. Thus, the scope of protection of the present invention is defined by the attached claims.

## Claims

1. Method for charging management, comprising:
using travel data of an electric vehicle of all historical days, including a current day, prior to a second day to estimate a possible depth of discharge (DOD) of a battery supplying power to the electric vehicle on the second day and a degree of ageing of the battery as of the current day, wherein the travel data indicates the variation with time of a travel speed of the electric vehicle on all the historical days;
determining an optimal state of charge (SOC) range of the battery corresponding to the estimated degree of ageing, on the basis of pre-acquired information indicating optimal SOC ranges of the battery corresponding to different degrees of ageing of the battery;
determining a maximum SOC of the battery when used on the second day, on the basis of the estimated possible DOD and the determined optimal SOC range; and
charging the battery to the maximum SOC, when the battery can be charged for use on the second day.

2. Method according to Claim 1, wherein the step of estimating the possible DOD of the battery on the second day comprises:
acquiring, on the basis of the travel data of all the historical days and a relationship between the travel speed of the electric vehicle and a discharge amount per unit time of the battery, the variation with time of the discharge amount per unit time of the battery on all the historical days;
determining the variation with time of an SOC of the battery on all the historical days, on the basis of the variation with time of the discharge amount per unit time of the battery on all the historical days;
calculating a DOD of the battery on all the historical days, on the basis of a maximum SOC and a minimum SOC in the variation with time of the SOC of the battery on all the historical days; and
calculating the possible DOD on the basis of the DOD of the battery on all the historical days.

3. Method according to Claim 1, wherein the step of estimating the degree of ageing of the battery as of the current day comprises:
determining a discharge time and a charge time of the battery on the current day, on the basis of the travel data of the current day;
appraising an ageing amount experienced by the battery on the current day, on the basis of the determined discharge time and charge time; and
determining the degree of ageing of the battery as of the current day, on the basis of the appraised ageing amount, a natural ageing amount experienced by the battery in one day and a degree of ageing of the battery as of the day before the current day.

4. Method according to Claim 1, wherein the step of estimating the degree of ageing of the battery as of the current day comprises:
determining a system state of the battery as of the current day; and
looking up, from a battery ageing curve lookup table for indicating different system states of the battery and degrees of ageing corresponding thereto, a degree of ageing corresponding to the system state of the battery as of the current day, to serve as the degree of ageing of the battery as of the current day.

5. Method according to Claim 1, wherein the step of determining the maximum SOC of the battery when used on the second day comprises:
determining an initial maximum SOC of the battery when used on the second day, using the estimated possible DOD and the determined optimal SOC range; and
adjusting the initial maximum SOC according to information for indicating weather conditions in a region where the electric vehicle is located, so as to obtain the maximum SOC of the battery when used on the second day.

6. Method according to Claim 1, further comprising:
using an optimization algorithm to calculate an optimal charging current distribution used to charge the battery to the maximum SOC, on the basis of a current remaining charge quantity, temperature and SOC of the battery and the degree of ageing of the battery as of the current day, the optimal charging current distribution indicating a length of time needed for charging and an optimal charging current at each moment during charging; and
determining a start time for charging the battery on the basis of a current moment and the length of time indicated by the optimal charging current distribution, when the battery can be charged for use on the second day,
wherein the step of charging the battery to the maximum SOC comprises: charging the battery in accordance with the optimal charging current at each moment during charging indicated by the optimal charging current distribution, when a current time reaches the start time.

7. Method according to Claim 1, further comprising:
determining an optimal charging current of the battery corresponding to the estimated degree of ageing, using pre-acquired information indicating optimal charging currents of the battery corresponding to different degrees of ageing of the battery,
wherein the step of charging the battery to the maximum SOC comprises: charging the battery in accordance with the determined optimal charging current, until the maximum SOC is reached, when the battery can be charged for use on the second day.

8. Method according to Claim 1, wherein the electric vehicle is a two-wheeled electric vehicle.

9. Apparatus for charging management, comprising:
an estimation module, for using travel data of an electric vehicle of all historical days, including a current day, prior to a second day to estimate a possible depth of discharge (DOD) of a battery supplying power to the electric vehicle on the second day and a degree of ageing of the battery as of the current day, wherein the travel data indicates the variation with time of a travel speed of the electric vehicle on all the historical days;
a first determining module, for determining an optimal state of charge (SOC) range of the battery corresponding to the estimated degree of ageing, on the basis of pre-acquired information indicating optimal SOC ranges of the battery corresponding to different degrees of ageing of the battery; and determining a maximum SOC of the battery when used on the second day, on the basis of the estimated possible DOD and the determined optimal SOC range; and
a charging module, for charging the battery to the maximum SOC, when the battery can be charged for use on the second day.

10. Apparatus according to Claim 9, wherein the estimation module comprises:
an acquisition module, for acquiring, on the basis of the travel data of all the historical days and a relationship between the travel speed of the electric vehicle and a discharge amount per unit time of the battery, the variation with time of the discharge amount per unit time of the battery on all the historical days;
a second determining module, for determining the variation with time of an SOC of the battery on all the historical days, on the basis of the variation with time of the discharge amount per unit time of the battery on all the historical days;
a first calculation module, for calculating a DOD of the battery on all the historical days, on the basis of a maximum SOC and a minimum SOC in the variation with time of the SOC of the battery on all the historical days; and
a second calculation module, for calculating the possible DOD on the basis of the DOD of the battery on all the historical days.

11. Apparatus according to Claim 9, wherein the estimation module comprises:
a third determining module, for determining a system state of the battery as of the current day; and
a lookup module, for looking up, from a battery ageing curve lookup table for indicating different system states of the battery and degrees of ageing corresponding thereto, a degree of ageing corresponding to the system state of the battery as of the current day, to serve as the degree of ageing of the battery as of the current day.

12. Apparatus according to Claim 9, wherein the first determining module comprises:
a fourth determining module, for determining an initial maximum SOC of the battery when used on the second day, using the estimated possible DOD and the determined optimal SOC range; and
an adjustment module, for adjusting the initial maximum SOC according to information for indicating weather conditions in a region where the electric vehicle is located, so as to obtain the maximum SOC of the battery when used on the second day.

13. Apparatus according to Claim 9, wherein the estimation module comprises:
a fifth determining module, for determining a discharge time and a charge time of the battery on the current day, on the basis of the travel data of the current day;
an appraisal module, for appraising an ageing amount experienced by the battery on the current day, on the basis of the determined discharge time and charge time; and
a sixth determining module, for determining the degree of ageing of the battery as of the current day, on the basis of the appraised ageing amount, a natural ageing amount experienced by the battery in one day and a degree of ageing of the battery as of the day before the current day.

14. Apparatus according to Claim 9, further comprising:
a third calculation module, for using an optimization algorithm to calculate an optimal charging current distribution used to charge the battery to the maximum SOC, on the basis of a current remaining charge quantity, temperature and SOC of the battery and the degree of ageing of the battery as of the current day, the optimal charging current distribution indicating a length of time needed for charging and an optimal charging current at each moment during charging; and
a seventh determining module, for determining a start time for charging the battery on the basis of a current moment and the length of time indicated by the optimal charging current distribution, when the battery can be charged for use on the second day,
wherein the charging module is used for: charging the battery in accordance with the optimal charging current at each moment during charging indicated by the optimal charging current distribution, when a current time reaches the start time.

15. Apparatus according to Claim 9, further comprising:
an eighth determining module, for determining an optimal charging current of the battery corresponding to the estimated degree of ageing, using pre-acquired information indicating optimal charging currents of the battery corresponding to different degrees of ageing of the battery,
wherein the the charging module is used for: charging the battery in accordance with the determined optimal charging current, until the maximum SOC is reached, when the battery can be charged for use on the second day.

16. Apparatus according to Claim 9, wherein the electric vehicle is a two-wheeled electric vehicle.

17. Charging device, comprising:
a processor; and
a memory, in which is stored an executable instruction which, when executed, causes the processor to perform the method according to any one of Claims 1-8.

18. Machine-readable storage medium, on which is stored an executable instruction which, when executed, causes a machine to perform the method according to any one of Claims 1 - 8.
